(19) Europäisches Patentamt

European Patent Office

Office européen des brevets

(11) Publication number: **0 424 018 A2**

# EUROPEAN PATENT APPLICATION

(21) Application number: **90311086.4**

(22) Date of filing: **10.10.90**

(51) Int. Cl.⁵: **H01L 21/32, H01L 21/76**

(30) Priority: **17.10.89 US 422844**

(43) Date of publication of application:
**24.04.91 Bulletin 91/17**

(84) Designated Contracting States:
**DE ES FR GB IT**

(71) Applicant: **AMERICAN TELEPHONE AND TELEGRAPH COMPANY**
**550 Madison Avenue**
**New York, NY 10022(US)**

(72) Inventor: **Fritzinger, Larry Bruce**
**6560 Osage Lane**
**Bethlehem, Pennsylvania 18017(US)**
Inventor: **Lee, Kuo-Hua**
**1308 Country Club Road**
**Wescosville, Pennsylvania 18106(US)**
Inventor: **Lu, Chih-Yuan**
**5371 Andrea Drive**
**Wescosville, Pennsylvania 18106(US)**
Inventor: **Sheng, Tan Tsu**
**125 Carlton Road**
**Millington, New Jersey 07946(US)**
Inventor: **Sung, Janmye**
**1109 Barnside Road**
**Allentown, Pennsylvania 18103(US)**

(74) Representative: **Johnston, Kenneth Graham et al**
**AT&T (UK) LTD. AT&T Intellectual Property Division 5 Mornington Road**
**Woodford Green Essex, IG8 OTU(GB)**

(54) Integrated circuit field isolation process.

㊼ A method for forming a field oxide structure in an integrated circuit is disclosed. The resulting structure exhibits minimal bird's beak formation and has dimensions smaller than what can be achieved by straightforward lithography. The process includes formation of a pad oxide (e.g., 13) and an overlying silicon nitride layer (e.g., 27) (an optional polysilicon stress buffer layer (e.g., 15) may be sandwiched between the oxide and nitride.) An opening is lithographically created in the oxide/ nitride stack. Then the oxide is wet etched to create a small gap underneath the overlying nitride. Next a nitride spacer (e.g., 29) is formed within the opening. The spacer has a foot-like protrusion (e.g., 27) into the gap. Then a field oxide (e.g., 29) is grown within the opening defined by the spacer.

## INTEGRATED CIRCUIT FIELD ISOLATION PROCESS

### Technical Field

This invention relates to semiconductor devices and methods for manufacturing them; more particularly, it relates to methods for fabricating interdevice isolation structures on a semiconductor chip.

### Background of the Invention

During the manufacture of transistor integrated circuits, it is both customary and necessary to provide a means for isolating individual transistors from one another. One popular method of device isolation is the LOCOS ("Local Oxidation of Silicon") process. In essence, the LOCOS process involves the formation of a silicon dioxide pad layer upon a bare silicon surface. The pad layer is then covered with silicon nitride. Both the pad layer and the silicon nitride layer are then patterned to expose portions of bare silicon. The bare silicon is subsequently oxidized to produce an isolation structure often termed a "field oxide."

Implementation of the LOCOS process may, however, present a variety of practical problems. The thermal oxidation process used to grow the field oxide causes a lifting of the edges of the silicon nitride layer. The tapered portion of the field oxide which extends beneath the edge of the silicon nitride layer is often termed a "bird's beak." The presence of the bird's beak effectively increases the size of the field oxide, thereby ultimately decreasing the amount of silicon real estate available for later device formation. Thus, because of bird's beak formation, the final size of the field oxide is generally larger than the original lithographic pattern imposed upon the silicon nitride layer.

Workers have attempted to decrease the size of the bird's beak by depositing thicker silicon nitride layers, hoping to suppress bird's beak growth. However, the thick nitride layer, while tending to suppress the outward growth of the bird's beak, also tends to generate defects and dislocations in the silicon substrate near the bird's beak.

One proposed solution to the dislocation problem is descriptively termed the "poly buffered LOCOS" process. In that process, a layer of polysilicon is formed between the pad oxide and the silicon nitride overlayer. The silicon nitride overlayer may be comparatively thick. The polysilicon layer, being somewhat more forgiving than the comparatively rigid silicon nitride overlayer, serves to absorb stresses generated during the thermal oxidation step. Consequently, the possibility of dislocation formation during the thermal oxidation step is reduced. However, practical experience with the poly buffered LOCOS has still shown an undesirable amount of bird's beak formation - perhaps, because the polysilicon layer compresses slightly, permitting undesirable outward growth of the silicon dioxide. Thus, a disadvantage to the use of a polysilicon buffer layer is that it tends to permit formation of the feature (i.e., bird's beak) which the overlying thick silicon nitride layer is designed to suppress.

Another approach to bird's beak reduction is illustrated in M. Ghezzo et al., "Laterally sealed LOCOS isolation," J. Electrochemical Society, 1475-1479 (1987). The Ghezzo et al. publication illustrates a method of field oxide formation using silicon nitride spacers with protrusions which extend into the field oxide. Unfortunately, the intense outward stresses generated during oxide growth tend to distort the spacer structure and are likely to create defects or dislocations in the underlying silicon substrate.

Those concerned with the development of very large scale integrated circuits have consistently sought methods of field oxide formation which reduce or eliminate bird's beak formation without deleterious effects upon the underlying substrate.

### Summary of the Invention

The present invention provides a method of field oxide formation with greatly reduced bird's beak formation and little risk of damage to the underlying substrate. In one illustrative embodiment of the present invention, a polysilicon layer is sandwiched between a pad oxide layer and a silicon nitride layer during the initial steps of wafer processing. The sandwich is patterned to expose bare silicon at the locations where a field oxide is desired. A wet clean is performed to remove a small portion of the pad oxide underneath the polysilicon layer. (An optional partial regrowth of the pad oxide may be performed at this juncture, if desired, to provide a stress relief for additional insurance against the subsequent formation of defects in the silicon substrate.) Next, a silicon nitride layer is deposited and anisotropically etched back to form a spacer. The spacer has a protruding foot which extends into the region where the pad oxide was removed by the previous wet cleaning step. Then a field oxide is formed. The forming process causes a slight lifting - but very little distortion of - the silicon nitride structure. However, bird's beak formation is minimal (and may be further reduced by subsequent etching). In another embodiment the polysilicon layer may be eliminated.

## Brief Description of the Drawing

FIGs. 1-5 and 7-10 are cross-sectional views illustrative of processes for performing the present invention; and
FIGs. 6 and 11 are perspective views illustrating a structure fabricated according to the present invention.

## Detailed Description

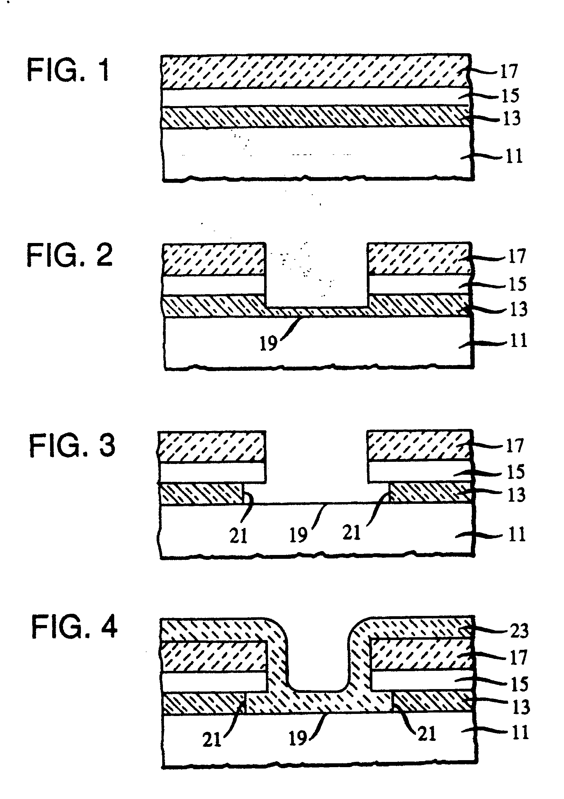

In FIG. 1, reference numeral 11 denotes a substrate which typically consists essentially of silicon or epitaxial silicon. Pad oxide 13 may be formed by conventional processes upon substrate 11. A typical thickness for pad oxide 13 is between 100Å and 300Å.

Polysilicon layer 15 may be formed upon pad oxide 13 by conventional processes. A typical thickness for polysilicon layer 15 is between 400Å and 600Å.

Silicon nitride layer 17 is formed upon polysilicon layer 15 by conventional processes.

A typical thickness for silicon nitride layer 17 is between 1500Å and 2800Å. It is possible to eliminate polysilicon layer 15. However, if layer 15 is eliminated, the thickness of layer 17 should be reduced to the approximate range of 800Å to 1300Å to avoid stress problems.

FIG. 2 depicts the structure of FIG. 1 after layers 13, 15 and 17 have been patterned to create opening 19. (The patterning may be accomplished by those skilled in the art. Usually a photoresist is deposited and portions selectively removed to create an opening in the photoresist. Then layers 17,15, and 13 may be etched through the opening.) It is desired to form a field oxide within opening 19.

Next a wet cleaning procedure is performed on the structure illustrated in FIG. 2. As illustrated in FIG. 3, the wet cleaning procedure tends to preferentially attack pad oxide 13, creating gap 21 beneath layer 15. A typical solution for performing the wet clean is 15:1 HF solution for approximately 1-2 minutes. Gap 21 desirably extends inward about 200-400Å.

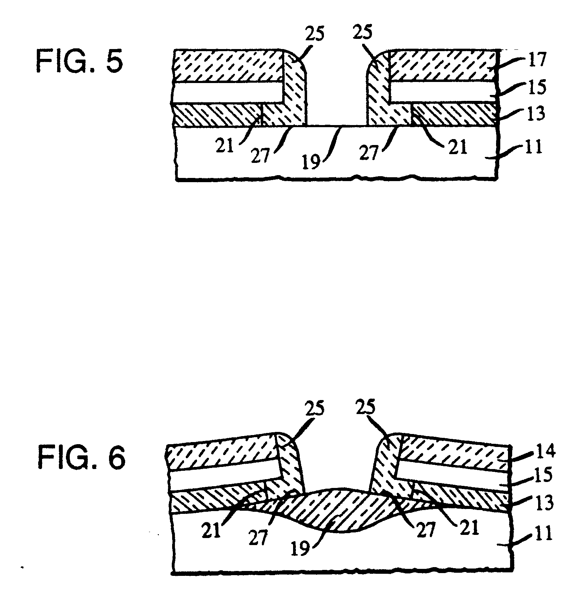

Turning to FIG. 4, silicon nitride layer 23 is blanket deposited (typically by one of various chemical vapor deposition techniques known to those skilled in the art) over the structure of FIG. 3. It will be noted that layer 23 protrudes into gap 21. In FIG. 5, layer 23 has been anisotropically etched to produce spacer 25 with foot-like protrusions 27. A typical suitable anisotropic etch process involves the use of trifluoromethane and oxygen in a ratio of 45:8 respectively. It will be noted that protrusions 27 extend *away* from opening 19 within which the field oxide is to be formed.

Next, the structure of FIG. 5 is subjected to thermal oxidation to produce the structure shown in the perspective view of FIG. 6. Typically, field oxide 29, may be formed by high pressure oxidation at 20-25 atm. at approximately 920°C for 15 minutes. However, other processes such as steam thermal oxidation at approximately 950°C-1000°C for approximately one hour may be used.

Although the formation of field oxides 29 causes some uplifting of spacer 25 together with foot-like protrusion 27, undesirable bird's beak formation is significantly reduced. It is believed that foot-like protrusions prevent migration of oxygen into layers 13 and 15 while simultaneously helping to prevent excessive lifting of the stack of layers 13,15, and 17 during formation of the field oxide. The bird's beak region 31 of field oxide 29 is substantially smaller than the bird's beak produced by, for example, a conventional LOCOS process.

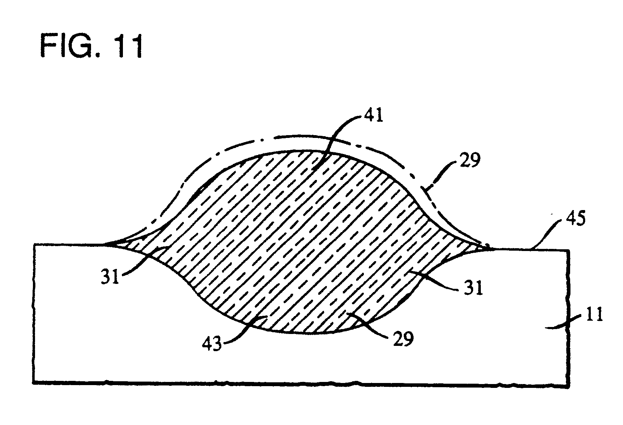

After field oxide 29 has been formed, layers 13,15, and 17 may be stripped by techniques well known to those skilled in the art. The remaining field oxide structure is depicted in FIG. 11. An isotropic etch may be performed using diluted HF or diluted buffered HF to further reduce the size of bird's beak 31. FIG. 11 illustrates field oxide 29 after an isotropic etch has been performed. The size of the field oxide before the isotropic etch is shown in phantom and designated by reference numeral 29'. It will be noted that the shape of field oxide 29 is comparatively symmetric about the outer surface 45 of substrate 11, i.e., the size and shape of upper portion 41 of field oxide is similar to the size and shape of lower portion 43. By contrast, field oxides formed from conventional poly buffered LOCOS processes tend to exhibit a disproportionate amount of oxide above the outer surface of the substrate (where it serves no useful purpose).

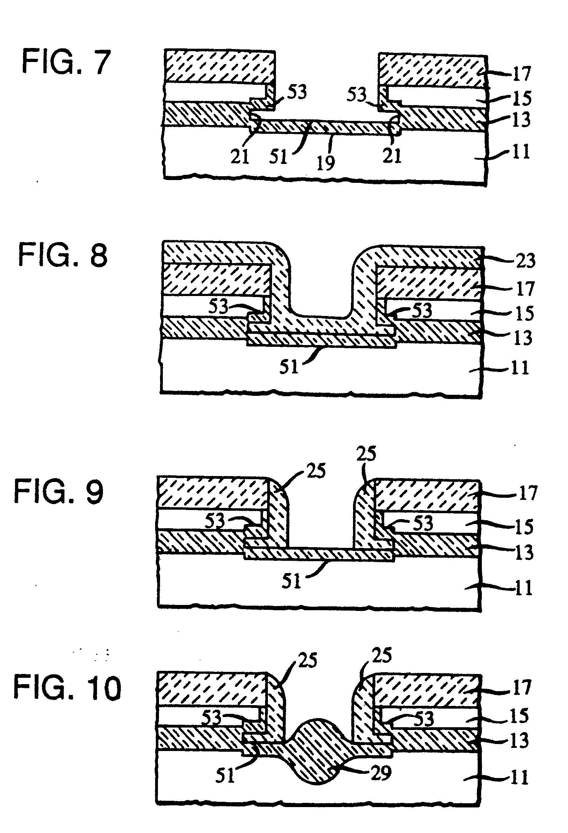

The inventive technique can be practiced in a variety of other ways. For example, FIGs. 7-10 illustrate an alternative process for forming a field oxide according to the present invention. The structure depicted in FIG. 7 is formed after the steps depicted by FIGs. 1-3 have been completed. Then, additional thin thermal oxide layers 51 and 53 are regrown (preferably in dry oxygen at approximately 850-900°C for approximately 40 minutes). The thickness of layers 51 and 53 is approximately 100Å. Layers 51 and 53 provide additional protection against the creation of defects in substrate 11. It will be noted that layer 51 is formed upon substrate 11 in opening 19, while layer 53 grows on the underside of polysilicon layer 15.

Next a processing sequence analogous to that depicted in FIGs. 4-6 is performed. The processing sequence is illustrated in detail in FIGs. 8-10. Referring to FIG. 8, silicon nitride layer 23 is deposited on the structure depicted in FIG. 7. Next, as illustrated in FIG. 9, spacers 25 are formed by anisotropic etching.

In FIG. 10, field oxide 29 is formed by conventional techniques such as those described previously. Finally, layers 13,15,17, and 53 together with spacers 25 are removed, leaving a structure similar to that depicted in FIG. 11. As mentioned before, an isotropic etch may be applied to further reduce the size of the resulting bird's beak.

As mentioned before, polysilicon layer 15 may be omitted. If layer 15 is omitted, of course, the processing sequence is simplified. However, as mentioned before, without a stress relief layer, it is desirable to make the overlying silicon nitride layer 17 somewhat thinner to avoid generation of defects. Because layer 17 is thinner, the bird's beak is not as effectively suppressed, and a slightly larger bird's beak occurs when polysilicon layer 15 is omitted.

The inventive process provides a variety of advantages over other isolation techniques. One advantage of the inventive process is that the size of the field oxide body is smaller than the smallest opening achievable by straightforward lithography. Spacer 25 effectively reduces the size of opening 19 and thus permits formation of a smaller field oxide than otherwise possible. The spacer also helps to prevent oxygen intrusion into layers 13 and 15.

The inventive process is expected to generate less silicon defects than the aforementioned Ghezzo et al. process because there is no tilting or bending distortion of the nitride spacer as exhibited in Ghezzo et al. The addition of a polysilicon layer between spacers in Ghezzo et al. will not alleviate the defect generation problem. By contrast, as shown schematically in FIG. 6, for example, the present invention does not exhibit bending or tilting of nitride spacer 25. The entire stack of layers 13,17 (and 15 if present) tilts somewhat gradually, thus lessening the likelihood of defect formation. The inward foot-like protrusions of applicants' spacer permit a slight raising of the nitride overlayer. However, by contrast, the outward protrusions of the Ghezzo et al. structure tend to drag the upper surface of the silicon as they tilt, thus contributing to defect formation.

forming at least a first (e.g., 13) and second (e.g., 17) material layers overlying a substrate (e.g., 11);
patterning said first (e.g., 13) and second (e.g., 17) layers to form an opening exposing said substrate;
**AND CHARACTERIZED BY** the additional steps of:
selectively removing a portion of said first layer (e.g., 13), creating a gap (e.g., 21) between a portion of said second (e.g., 17) layer and said substrate (e.g., 11);
forming a spacer (e.g., 25) within said opening, said spacer (e.g., 25) having a protrusion (e.g., 27) within said gap (e.g., 21);
forming an oxide (e.g., 23) of said substrate material, said oxide being substantially enclosed by said spacer.

2. The method of claim 1 wherein
said substrate (e.g., 11) consists essentially of silicon;
said first layer(e.g., 13) consists essentially of silicon dioxide; and
said second layer (eg., 17) consists essentially of silicon nitride.

3. The method of claim 1 further including the steps of:
removing said first (e.g., 13) and second layers (e.g., 17) and said spacer (e.g., 25); and
etching said oxide (e.g., 29).

4. The method of claim 1 further including the step of forming a third (e.g., 15) layer between said first (e.g., 13) and second (e.g., 17) layers, said third (e.g., 15) layer serving to provide stress relief.

5. The method of claim 4 wherein said third (e.g., 15) layer is polysilicon.

6. The method of claim 1 further including the additional step of forming an oxide (e.g., 51) upon said exposed (e.g., 19) portion of said substrate prior to said spacer (e.g., 25) forming step.

7. The method of claim 1 in which said oxide (e.g., 29) is formed by high pressure oxidation.

## Claims

1. A method of semiconductor fabrication comprising:

FIG. 1

— 17
— 15
— 13

— 11

FIG. 2

— 17
— 15
— 13

19 — 11

FIG. 3

— 17
— 15
— 13

21     19     21     — 11

FIG. 4

— 23
— 17
— 15
— 13

21     19     21     — 11

FIG. 5

FIG. 6

FIG. 7

FIG. 8

FIG. 9

FIG. 10

7

## FIG. 11